# FASCICULE DE BREVET EUROPEEN

(11) **EP 4 369 085 B1**
(45) Date de publication et mention de la délivrance du brevet: **28.05.2025**
(21) Numéro de dépôt: 23204548.4
(22) Date de dépôt: 19.10.2023
(51) Int. Cl.: G02F 1/1333, H10K 59/18, G09F 9/302

(54) **ÉCRAN D'AFFICHAGE COMPRENANT UN PANNEAU D'AFFICHAGE ET PROCÉDÉ DE FABRICATION D'UN TEL ÉCRAN D'AFFICHAGE**
ANZEIGEBILDSCHIRM MIT ANZEIGETAFEL UND VERFAHREN ZUR HERSTELLUNG SOLCH EINER ANZEIGEBILDSCHIRM
DISPLAY SCREEN INCLUDING DISPLAY PANEL AND METHOD FOR MANUFACTURING SUCH DISPLAY SCREEN

(30) Priorité: 09.11.2022 FR 2211659
(43) Date de publication de la demande: 15.05.2024
(73) Titulaire: Aledia, 38130 Échirolles (FR)
(72) Inventeur: LEBRUN, Hugues, 38500 COUBLEVIE (FR)
(74) Mandataire: Germain Maureau

(56) Documents cités:
- JP-A- 2005 017 738
- US-A1- 2003 234 343
- US-A1- 2022 093 712

## Description

### Domaine technique de l'invention

La présente invention concerne les dispositifs d'affichages, et plus particulièrement les dispositifs d'affichage comprenant un ou plusieurs panneaux d'affichage, par exemple utilisés pour former des murs d'image.

L'invention concerne également un procédé de fabrication d'un tel écran d'affichage.

### Etat de la technique

Pour former un écran d'affichage de grande dimension, appelé communément un mur d'image, il est nécessaire d'assembler une pluralité de panneaux d'affichages constituant les briques élémentaires, ou les tuiles du mur d'image. Ces briques élémentaires ont généralement une périphérie invisible grâce à la présence de pixels lumineux sur les bords de la surface du dispositif élémentaire.

L'utilisation d'un grand nombre de briques élémentaires de taille relativement petite par rapport à celle du mur d'image est nécessaire, car les moyens de fabrications ne permettent pas de réaliser directement des murs d'image à l'échelle 1. De manière générale, la dimension maximale des briques élémentaires est de 500*600mm.

Les avancées réalisées dans le domaine des diodes électroluminescentes (LED) permettent de miniaturiser la taille des LEDs et d'augmenter de cette manière la résolution des écrans.

Toutefois, avec l'augmentation de la résolution, il est nécessaire de diminuer également la taille des briques élémentaires, pour pouvoir conserver une bonne précision de positionnement des LEDs, et des circuits électroniques (PCB) éventuellement associés à ces LEDs. Par ailleurs, en augmentant la résolution des écrans, le pas dimensionnel séparant deux pixels est diminué, ce qui nuit à une bonne précision de positionnement au bord des briques élémentaires. Les conséquences sont que si le pas d'image se réduit, la distance entre le dernier point d'image d'une brique élémentaire et le premier point d'image d'une brique élémentaire adjacente se réduit également.

En conclusion, plus la résolution des briques élémentaires augmente, plus il est difficile de rendre invisibles ou indétectables les jonctions entre les différentes briques élémentaires. Par ailleurs, l'œil humain est davantage sensible aux jonctions rectilignes, ce qui est le cas dans la plupart des murs d'image. Les jonctions entre les briques élémentaires sont donc bien plus visibles à mesure que la résolution des briques élémentaires augmente, ce qui est dommageable pour la perception de l'image affichée. Les documents US 2003/234343 A1, JP 2005 017738 A et US 2022/093712 A1 font partie de l'état de la technique antérieure utile à la compréhension de l'invention.

### Objet de l'invention

La présente invention a pour but de proposer une solution qui réponde à tout ou partie des problèmes précités.

Ce but peut être atteint grâce à la mise en œuvre d'un panneau d'affichage pour écran d'affichage selon la revendication 1, l'écran d'affichage étant destiné à comprendre une pluralité de tels panneaux d'affichage disposés côte à côte, ledit panneau d'affichage comprenant :
- un support comprenant une première surface de réception et une première épaisseur comptée transversalement à la première surface de réception, ladite première surface de réception comprenant au moins un premier bord périphérique et incluant intérieurement au moins une première portion de raccordement adjacente audit au moins un premier bord périphérique de la première surface de réception ;
- une matrice de premiers pixels définie par une organisation matricielle caractérisée par un premier axe, un deuxième axe, et un premier pas régulier, ladite matrice de premiers pixels comprenant des premiers pixels agencés sur tout ou partie de la première surface de réception et en dehors de la première portion de raccordement, de manière régulière selon l'organisation matricielle, et des premiers pixels agencés, au sein de l'au moins une première portion de raccordement, le long :
   o d'au moins une première ligne périphérique orientée suivant le premier axe et comprenant un premier ensemble d'emplacements échelonnés à intervalles réguliers espacés entre eux suivant ledit premier pas régulier, le nombre de premiers pixels appartenant à ladite première ligne périphérique étant strictement inférieur au nombre d'emplacements inclus dans ledit premier ensemble de sorte qu'au moins un emplacement du premier ensemble soit dépourvu de pixel;
   o et/ou d'au moins une première colonne périphérique orientée suivant le deuxième axe et comprenant un deuxième ensemble d'emplacements échelonnés à intervalles réguliers espacés entre eux suivant ledit premier pas régulier, le nombre de premiers pixels appartenant à ladite première colonne périphérique étant strictement inférieur au nombre d'emplacements inclus dans ledit deuxième ensemble de sorte qu'au moins un emplacement du deuxième ensemble soit dépourvu de pixel ;
- une pluralité de premiers éléments électriquement conducteurs configurés pour assurer une connexion électrique entre tout ou partie des premiers pixels ;
au moins un emplacement choisi parmi ledit au moins un emplacement du premier ensemble dépourvu de pixel et ledit au moins un emplacement du deuxième ensemble dépourvu de pixel formant une première zone de jonction de la première portion de raccordement , le support comprenant, au niveau de la première zone de jonction , une ouverture de jonction ménagée à travers la première épaisseur du support, ladite ouverture de jonction étant disjointe du premier bord périphérique de la première surface de réception.

Les dispositions précédemment décrites permettent de proposer un panneau d'affichage pour écran d'affichage dans lequel un alignement rectiligne des pixels sur un bord périphérique du panneau d'affichage est évité afin d'empêcher la visualisation de lignes droites au niveau de jonctions entre plusieurs panneaux d'affichage, une fois que le panneau d'affichage est assemblé à d'autres panneaux d'affichage pour former un écran d'affichage.

Le panneau d'affichage peut en outre présenter une ou plusieurs des caractéristiques suivantes, prises seules ou en combinaison.

Selon un mode de réalisation, la première surface de réception est plane.

Selon un mode de réalisation, le premier axe est perpendiculaire au deuxième axe.

Selon un mode de réalisation, le panneau d'affichage est adapté pour la formation d'une boîte à lumière ou éclairage arrière ou BLU pour « Back Lightning Unit » pour écran à cristal liquide selon la terminologie anglo-saxonne consacrée.

Selon un mode de réalisation qui n'est pas selon l'invention telle que revendiquée, ladite au moins une ouverture de jonction est ménagée sur le premier bord périphérique de la première surface de réception, de sorte que le premier bord périphérique de la première surface de réception comprenne une portion non rectiligne. En d'autres termes, la première zone de jonction correspond à un découpage non rectiligne du premier bord périphérique de la première surface de réception.

Selon un mode de réalisation qui n'est pas selon l'invention telle que revendiquée, le premier bord périphérique est une ligne brisée ou une ligne courbe. Par exemple, le premier bord périphérique comprend au moins une portion non rectiligne concave, c'est-à-dire formant une bosse le long du bord périphérique, et/ou au moins une portion non rectiligne convexe, c'est-à-dire formant un creux le long du premier bord périphérique.

Selon l'invention telle que revendiquée, ladite au moins une ouverture de jonction est disjointe du premier bord périphérique de la première surface de réception.

Les dispositions précédemment décrites permettent de former la première zone de jonction simplement à partir d'un panneau d'affichage comprenant les pixels.

Selon un mode de réalisation, la première surface de réception est une surface de forme quadrilatérale.

Selon un mode de réalisation, la première surface de réception comprend une première longueur correspondant à une plus grande dimension comptée le long du premier axe, et une première hauteur correspondant à une plus grande dimension comptée le long du deuxième axe.

Par exemple, la surface de réception du panneau d'affichage peut présenter une forme générale de parallélogramme, de rectangle, ou de carré. De cette manière, la fabrication et l'assemblage de plusieurs panneaux d'affichages est facilitée.

Selon un mode de réalisation, la première surface de réception comprend une ouverture d'assemblage ménagée à travers la première épaisseur du support, au niveau d'un coin de la première surface de réception quadrilatérale.

De cette manière, il est possible de former un écran d'affichage par une superposition partielle d'une pluralité de panneaux d'affichage tout en limitant les surépaisseurs au niveau des coins.

Le but de l'invention peut également être atteint grâce à la mise en œuvre d'un écran d'affichage comprenant :
- un premier panneau d'affichage selon l'un des modes de réalisation précédemment décrits;
- un deuxième panneau d'affichage distinct du premier panneau d'affichage et comprenant :
   ∘ un deuxième support comprenant une deuxième surface de réception et une deuxième épaisseur comptée transversalement à la deuxième surface de réception, ladite deuxième surface de réception comprenant au moins un deuxième bord périphérique et incluant intérieurement au moins une deuxième portion de raccordement adjacente audit au moins un deuxième bord périphérique de la deuxième surface de réception ;
   ∘ une matrice de deuxièmes pixels définie par une organisation matricielle identique à celle de la matrice de premiers pixels du premier panneau d'affichage, ladite matrice de deuxièmes pixels comprenant des deuxièmes pixels agencés, sur tout ou partie de la deuxième surface de réception et en dehors de la deuxième portion de raccordement, de manière régulière selon l'organisation matricielle, et des deuxièmes pixels agencés à intervalles réguliers espacés entre eux suivant le premier pas régulier au sein de la deuxième portion de raccordement, la deuxième portion de raccordement comprenant une deuxième zone de jonction complémentaire de la première zone de jonction, et configurée pour coopérer avec la première zone de jonction de la première portion de raccordement du premier panneau d'affichage de sorte qu'au moins un deuxième pixel agencé au niveau de la deuxième zone de jonction soit disposé au niveau d'un emplacement de la première zone de jonction ; et
   ∘ une pluralité de deuxièmes éléments électriquement conducteurs configurés pour assurer une connexion électrique entre tout ou partie des deuxièmes pixels.

Les dispositions précédemment décrites permettent d'assembler un premier panneau d'affichage et un deuxième panneau d'affichage de sorte à former un écran d'affichage. De manière avantageuse, la coopération entre la première zone de jonction de la première portion de raccordement et la deuxième zone de jonction de la deuxième portion de raccordement permet de masquer tout éventuel effet de jonction rectiligne entre le premier panneau d'affichage et le deuxième panneau d'affichage. En d'autres termes, il est possible de rendre floue la jonction entre les deux panneaux d'affichage par la coopération de la première portion de raccordement avec la deuxième portion de raccordement, car les premiers pixels et deuxièmes pixels au niveau de la jonction des deux panneaux d'affichage, ne sont plus forcément alignés suivant le premier axe ou selon le deuxième axe de l'autre panneau d'affichage. Cependant, dans l'écran d'affichage résultant de l'assemblage du premier panneau et du deuxième panneau tous les pixels de la première zone de jonction et de la deuxième zone de jonction sont parfaitement alignés suivant le premier axe et/ou selon le deuxième axe.

Il est bien compris que l'utilisation des termes « premier » et « deuxième » n'est pas limitative et que selon le mode de réalisation, il peut y avoir au moins un panneau d'affichage supplémentaire de même nature que les premier et deuxième panneaux d'affichage et pour lequel les mêmes principes qu'eux s'appliquent.

L'écran d'affichage peut en outre présenter une ou plusieurs des caractéristiques suivantes, prises seules ou en combinaison.

Selon un mode de réalisation, la pluralité de premiers éléments électriquement conducteurs, et la pluralité de deuxièmes éléments électriquement conducteurs sont commandés électriquement de manière conjointe.

Alternativement, la pluralité de premiers éléments électriquement conducteurs, et la pluralité de deuxièmes éléments électriquement conducteurs sont commandés électriquement individuellement. En d'autres termes, le premier panneau d'affichage et le deuxième panneau d'affichage sont commandés électriquement individuellement via les premiers et deuxièmes éléments électriquement conducteurs.

Selon un mode de réalisation, le deuxième panneau d'affichage est un panneau d'affichage selon l'un des modes de réalisation décrit précédemment.

Il est donc bien compris que chaque panneau d'affichage peut comprendre une ou plusieurs portions de raccordement comprenant chacune une ou plusieurs zones de jonction.

Par exemple, chaque panneau d'affichage peut comprendre une portion de raccordement au niveau de chaque bord de la surface de réception. Ainsi, il est possible d'obtenir un écran d'affichage de grande dimension par l'assemblage d'une pluralité de panneaux d'affichage. La présence de portions de raccordement entre deux panneaux d'affichage adjacents permet de rendre les jonctions entre les panneaux d'affichage floue, permettant ainsi d'éviter la formation de jonctions rectilignes visible à l'œil nu.

Selon l'invention telle que revendiquée, la première zone de jonction du premier panneau d'affichage comprend au moins une ouverture de jonction ménagée à travers la première épaisseur du support du premier panneau d'affichage, au niveau de laquelle la deuxième zone de jonction du deuxième panneau d'affichage coopère avec la première zone de jonction du premier panneau d'affichage.

Selon un mode de réalisation, la première zone de jonction coopère avec la deuxième zone de jonction par superposition. De cette manière, il est possible d'assembler le premier panneau d'affichage et le deuxième panneau d'affichage par tuilage, ce qui simplifie l'assemblage de l'écran d'affichage.

Selon un mode de réalisation qui n'est pas selon l'invention telle que revendiquée, l'ouverture de jonction de la première zone de jonction du premier panneau d'affichage est ménagée sur le premier bord périphérique de la première surface de réception, et la deuxième zone de jonction de la deuxième portion de raccordement forme le deuxième bord périphérique de la deuxième surface de réception, la deuxième zone de jonction s'étendant en saillie depuis la deuxième surface de réception, le premier bord périphérique de la première surface de réception ayant une forme complémentaire du deuxième bord périphérique de la deuxième surface de réception, la deuxième zone de jonction et la première zone de jonction étant disposées côte à côte dans le plan de la première surface de réception et de la deuxième surface de réception.

Selon un mode de réalisation qui n'est pas selon l'invention telle que revendiquée, la deuxième zone de jonction de la deuxième portion de raccordement fait saillie dans le plan de la deuxième surface de réception.

Selon un mode de réalisation qui n'est pas selon l'invention telle que revendiquée, le premier bord périphérique de la première surface de réception est formé par un découpage non rectiligne de la première surface de réception, et le deuxième bord périphérique de la deuxième surface de réception est formé par un découpage non rectiligne de la deuxième surface de réception, et complémentaire du découpage de la première surface de réception.

Selon un mode de réalisation qui n'est pas selon l'invention telle que revendiquée, le premier bord périphérique de la première surface de réception est dentelé ou crénelé.

Selon un mode de réalisation, le deuxième bord périphérique de la deuxième surface de réception est dentelé ou crénelé.

Selon un mode de réalisation qui n'est pas selon l'invention telle que revendiquée, le premier et/ou le deuxième bord périphérique est une ligne brisée ou une ligne courbe. Par exemple, ledit premier ou deuxième bord périphérique comprend au moins une portion non rectiligne concave, c'est-à-dire formant une bosse le long du bord périphérique, et/ou au moins une portion non rectiligne convexe, c'est-à-dire formant un creux le long du premier bord périphérique.

Selon un mode de réalisation, la première surface de réception du premier panneau d'affichage est une surface de forme quadrilatérale, et la deuxième surface de réception du deuxième panneau d'affichage est une surface de forme quadrilatérale, lesdites formes quadrilatérales de la première surface de réception et de la deuxième surface de réception étant des formes quadrilatérales de même nature.

Par « formes quadrilatérales de même nature », on entend des formes quadrilatérales définies par le même type de quadrilatère, un type de quadrilatère étant par exemple choisi parmi : un carré, un rectangle, un losange, un parallélogramme, un trapèze, ou tout autre quadrilatère.

Selon un mode de réalisation, la première surface de réception et/ou la deuxième surface de réception présente/nt une forme générale de polygone.

Les dispositions précédemment décrites permettent d'assembler plus simplement une pluralité de panneaux d'affichage pour former l'écran d'affichage.

Selon un mode de réalisation, au moins un panneau d'affichage choisi parmi le premier panneau d'affichage et le deuxième panneau d'affichage comprend une ouverture d'assemblage ménagée à travers l'épaisseur du support dudit au moins un panneau d'affichage, au niveau d'un coin de la surface de réception quadrilatérale de ce panneau d'affichage.

Il est donc bien compris que la surface totale de la surface de réception quadrilatérale est diminuée par le retrait de l'ouverture d'assemblage.

Avantageusement, il peut être prévu qu'un coin d'une surface de réception d'un panneau d'affichage adjacent au panneau d'affichage comprenant l'ouverture d'assemblage vienne compléter la surface de réception au niveau de l'ouverture d'assemblage.

Selon un mode de réalisation, une première longueur d'un premier côté de la première surface de réception du premier panneau d'affichage est un multiple d'une deuxième longueur d'un deuxième côté de la deuxième surface de réception du deuxième panneau d'affichage.

Selon un mode de réalisation, la deuxième surface de réception comprend une deuxième longueur correspondant à une plus grande dimension comptée le long du premier axe, et une deuxième hauteur correspondant à une plus grande dimension comptée le long du deuxième axe.

Selon un mode de réalisation la deuxième longueur est un multiple de la première longueur ou inversement. Par exemple la deuxième longueur est égale à la première longueur.

Selon un mode de réalisation, la deuxième hauteur est un multiple de la deuxième longueur, ou inversement. Par exemple la deuxième hauteur est égale à la deuxième longueur.

Selon un mode de réalisation, au moins une portion de raccordement choisie parmi la première portion de raccordement et la deuxième portion de raccordement comprend une première zone de jonction et une deuxième zone de jonction.

Selon un mode de réalisation, l'écran d'affichage comprend un élément de connexion électrique configuré pour assurer une connexion électrique entre tout ou partie des deuxièmes éléments électriquement conducteurs du deuxième panneau d'affichage et tout ou partie des premiers éléments électriquement conducteurs du premier panneau d'affichage.

De cette manière, tous les premiers pixels et les deuxièmes pixels peuvent être alimentés simultanément en énergie électrique.

Selon un mode de réalisation, l'élément de connexion électrique comprend une pluralité d'aiguilles conductrices traversant au moins partiellement la première épaisseur du support du premier panneau d'affichage et traversant au moins partiellement une deuxième épaisseur du support du deuxième panneau d'affichage, ladite deuxième épaisseur du support du deuxième panneau d'affichage étant comptée transversalement à la deuxième surface de réception.

Selon un mode de réalisation, l'élément de connexion électrique comprend un agent adhésif électriquement conducteur.

De cette manière, l'élément de connexion électrique permet d'assurer à la fois la connexion électrique entre les premiers pixels, et les deuxièmes pixels, mais aussi de maintenir mécaniquement le premier panneau d'affichage et le deuxième panneau d'affichage.

Selon un mode de réalisation, au moins une épaisseur choisie parmi la première épaisseur et la deuxième épaisseur, est comprise entre 25 µm et 700 µm.

Les dispositions précédemment décrites permettent de proposer un écran d'affichage ayant une épaisseur très mince, de manière à ce que les pixels ou les diodes électroluminescentes soient bien visibles dans tous les angles de vue, et de manière à ce qu'elles soient quasiment dans le même plan. Ainsi, il est possible d'éviter que certaines diodes électroluminescentes soient en retrait par rapport aux autres. Par ailleurs, dans le cas où la première épaisseur et la deuxième épaisseur sont inférieures à 200 µm, il est possible d'obtenir un écran d'affichage flexible.

Selon un mode de réalisation, la première épaisseur est comprise entre 25 µm et 200 µm, et la deuxième épaisseur, est strictement supérieure à 700 µm. Dans ce cas il est possible de placer le premier panneau d'affichage au-dessus du deuxième panneau d'affichage.

Enfin, le but de l'invention peut être atteint par la mise en œuvre d'un procédé de fabrication d'un écran d'affichage selon la revendication 12 et comprenant :
- une étape de fourniture d'un premier panneau d'affichage selon l'un des modes de réalisation décrits ci-avant ;
- une étape de fourniture d'un deuxième panneau d'affichage comprenant :
   ∘ un deuxième support comprenant une deuxième surface de réception, ladite deuxième surface de réception comprenant au moins un deuxième bord périphérique et incluant intérieurement au moins une deuxième portion de raccordement adjacente audit au moins un deuxième bord périphérique de la deuxième surface de réception ;
   ∘ une matrice de deuxièmes pixels définie par une organisation matricielle identique à celle de la matrice de premiers pixels du premier panneau d'affichage, ladite matrice de deuxièmes pixels comprenant des deuxièmes pixels agencés, sur tout ou partie de la deuxième surface de réception et en dehors de la deuxième portion de raccordement, de manière régulière selon l'organisation matricielle, et des deuxièmes pixels agencés à intervalles réguliers espacés entre eux suivant le premier pas régulier au sein de la deuxième portion de raccordement, la deuxième portion de raccordement comprenant une deuxième zone de jonction configurée pour coopérer avec la première zone de jonction de la première portion de raccordement du premier panneau d'affichage de sorte qu'au moins un deuxième pixel agencé au niveau de la deuxième zone de jonction soit disposé au niveau d'un emplacement de la première zone de jonction ;
   ∘ une pluralité de deuxièmes éléments électriquement conducteurs configurés pour assurer une connexion électrique entre tout ou partie des deuxièmes pixels ;
- une étape d'assemblage de l'écran d'affichage dans laquelle le premier panneau d'affichage et le deuxième panneau d'affichage sont assemblés de sorte qu'un deuxième pixel du deuxième panneau d'affichage soit disposé au niveau de la première zone de jonction de la première portion de raccordement du premier panneau d'affichage.

Les dispositions précédemment décrites permettent de proposer un procédé de fabrication d'un écran d'affichage comprenant plusieurs panneaux d'affichage, la jonction rectiligne entre deux panneaux d'affichage adjacents de l'écran d'affichage étant rendue floue par le positionnement d'au moins un deuxième pixel au niveau de la première zone de jonction de la première portion de raccordement.

Le procédé de fabrication peut en outre présenter une ou plusieurs des caractéristiques suivantes, prises seules ou en combinaison.

Selon un mode de réalisation, l'étape de fourniture du premier panneau d'affichage comprend :
- une étape de mise à disposition d'un premier panneau d'affichage initial comprenant :
   ∘ le premier support ;
   ∘ une matrice initiale de premiers pixels définie par l'organisation matricielle, ladite matrice initiale de premiers pixels comprenant des premiers pixels agencés sur tout ou partie de la première surface de réception de manière régulière selon l'organisation matricielle ;
   ∘ la pluralité de premiers éléments électriquement conducteurs configurés pour assurer une connexion électrique entre tout ou partie des premiers pixels ;
- une étape de formation d'une première zone de jonction dans laquelle au moins un premier pixel est supprimé d'au moins un emplacement choisi parmi le premier ensemble et le deuxième ensemble, de sorte que ledit au moins un emplacement soit dépourvu de pixel.

Selon un mode de réalisation, l'étape de formation de la première zone de jonction comprend la formation d'au moins une ouverture de jonction à travers la première épaisseur du support du premier panneau d'affichage, l'étape d'assemblage de l'écran d'affichage comprenant alors la superposition de la première portion de raccordement du premier panneau d'affichage et de la deuxième portion de raccordement du deuxième panneau d'affichage.

Selon un mode de réalisation, au moins une surface de réception choisie parmi la première surface de réception du premier panneau d'affichage et la deuxième surface de réception du deuxième panneau d'affichage est une surface de forme quadrilatérale, le procédé de fabrication comprenant une étape de création d'une ouverture d'assemblage, dans laquelle une ouverture d'assemblage est créée au niveau d'un coin de ladite au moins une surface de réception.

### Description sommaire des dessins

D'autres aspects, buts, avantages et caractéristiques de l'invention apparaîtront mieux à la lecture de la description détaillée suivante de modes de réalisation préférés de celle-ci, donnée à titre d'exemple non limitatif, et faite en référence aux dessins annexés sur lesquels :
La figure 1 est une vue schématique d'un panneau d'affichage selon un mode de réalisation de l'invention.
La figure 2 est une vue schématique d'un écran d'affichage selon un mode de réalisation de l'invention.
La figure 3 est une vue schématique d'un écran d'affichage selon un autre mode de réalisation de l'invention.
La figure 4 est une vue schématique d'un écran d'affichage selon un autre mode de réalisation de l'invention.
La figure 5 est une vue schématique en coupe d'un écran d'affichage selon un mode de réalisation de l'invention.
La figure 6 est une vue schématique d'un écran d'affichage selon un autre mode de réalisation de l'invention.

### Description détaillée

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux.

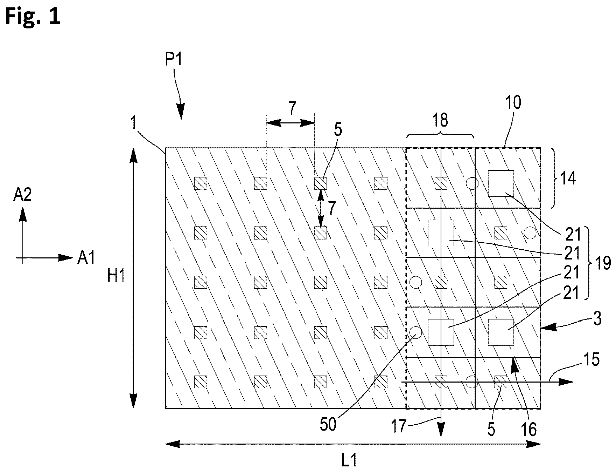

Comme cela est illustré sur les figures 1 à 6, l'invention concerne un panneau d'affichage P1, P2 pour écran d'affichage noté « S », et concerne également un tel écran d'affichage S comprenant une pluralité de tels panneaux d'affichage P1, P2 disposés côte à côte. Le panneau d'affichage P1, P2 est également adapté pour la formation d'une boîte à lumière, appelée également éclairage arrière ou BLU pour « Back Lightning Unit » pour écran à cristal liquide, selon la terminologie anglo-saxonne consacrée.

Le panneau d'affichage P1, P2 selon l'invention comprend tout d'abord un support comprenant une première surface de réception 1 et une première épaisseur e1 comptée transversalement à la première surface de réception 1. De manière générale, la première surface de réception 1 est plane et présente une surface de forme quadrilatérale. Cette première surface de réception 1 est destinée à recevoir des premiers pixels 5 répartis sur la première surface de réception 1. Ainsi, le panneau d'affichage P1, P2 comprend également une matrice desdits premiers pixels 5 définie par une organisation matricielle caractérisée par un premier axe A1 et un deuxième axe A2 perpendiculaires entre eux, ainsi que par un premier pas 7 régulier. Il est donc bien compris que les premiers pixels 5 sont disposés sur la première surface de réception 1 le long du premier axe A1, et du deuxième axe A2, et espacés les uns des autres par le premier pas 7. La première surface de réception 1 peut comprendre une première longueur L1 correspondant à une plus grande dimension comptée le long du premier axe A1, et une première hauteur H1 correspondant à une plus grande dimension comptée le long du deuxième axe A2. Par exemple, la surface de réception du panneau d'affichage P1, P2 peut présenter une forme générale de parallélogramme, de rectangle, ou de carré. De cette manière, la fabrication et l'assemblage de plusieurs panneaux d'affichages est facilitée. La première surface de réception 1 comprend au moins un premier bord périphérique 3 et comprend intérieurement au moins une première portion de raccordement 10 adjacente à ce premier bord périphérique 3.

La matrice de premiers pixels 5 comprend des premiers pixels 5 agencés sur tout ou partie de la première surface de réception 1 en dehors de la première portion de raccordement 10, de manière régulière selon l'organisation matricielle. La matrice de premiers pixels 5 comprend en outre des premiers pixels 5 agencés, au sein de l'au moins une première portion de raccordement 10, le long d'au moins une première ligne périphérique 15 orientée suivant le premier axe A1 et/ou d'au moins une première colonne périphérique 17 orientée suivant le deuxième axe A2. Comme on peut le voir sur la figure 1, la première portion de raccordement 10 comprend un premier ensemble 14 d'emplacements échelonnés à intervalles réguliers espacés entre eux suivant ledit premier pas 7 régulier. Dans ce premier ensemble 14, le nombre de premiers pixels 5 appartenant à la première ligne périphérique 15 est strictement inférieur au nombre d'emplacements inclus dans le premier ensemble 14 de sorte qu'au moins un emplacement du premier ensemble 14 soit dépourvu de pixel. De la même manière, la première portion de raccordement 10 peut aussi comprendre un deuxième ensemble 18 d'emplacements échelonnés à intervalles réguliers espacés entre eux suivant ledit premier pas 7 régulier. Dans ce deuxième ensemble 18, le nombre de premiers pixels 5 appartenant à la première colonne périphérique 17 est strictement inférieur au nombre d'emplacements inclus dans le deuxième ensemble 18 de sorte qu'au moins un emplacement du deuxième ensemble 18 soit dépourvu de pixel. La réunion des emplacements du premier ensemble 14 et du deuxième ensemble 18 dépourvus de pixels, forme une première zone de jonction 19 de la première portion de raccordement 10.

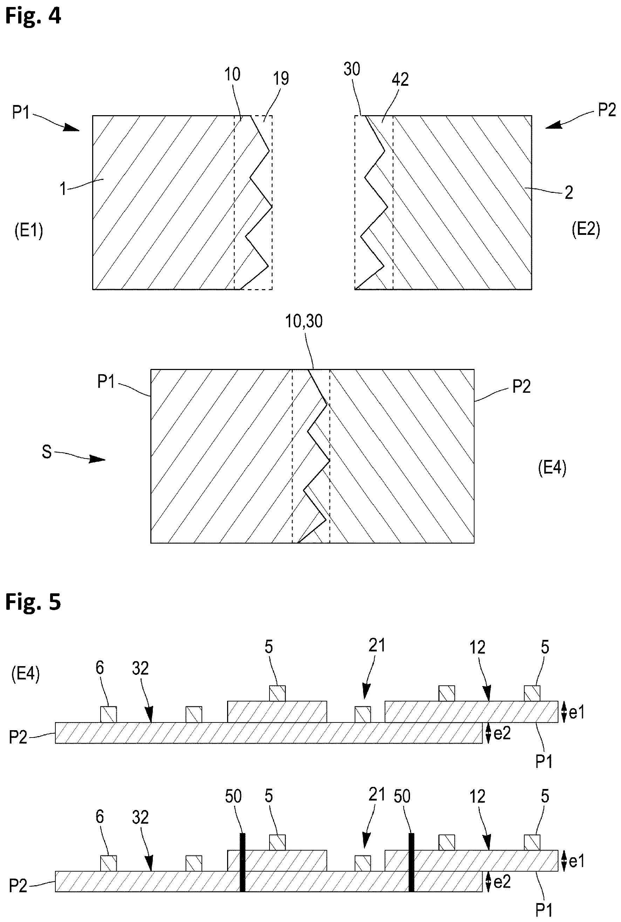

Le support peut comprendre au niveau de la première zone de jonction 19, une ouverture de jonction 21 ménagée à travers la première épaisseur e1 du support. Selon une première variante illustrée sur les figures 1 à 3 et conforme à l'invention telle que revendiquée, cette ouverture de jonction 21 est disjointe du premier bord périphérique 3 de la première surface de réception 1. Dans ce cas, l'ensemble des bords du support forment toujours un panneau d'affichage P1, P2 de forme rectangulaire. Selon une deuxième variante représentée sur la figure 4 et ne correspondant pas à l'invention telle que revendiquée, l'ouverture de jonction 21 est ménagée sur le premier bord périphérique 3 de la première surface de réception 1, de sorte que le premier bord périphérique 3 de la première surface de réception 1 comprenne une portion non rectiligne. En d'autres termes, la première zone de jonction 19 correspond à un découpage non rectiligne du premier bord périphérique 3 de la première surface de réception 1. Par exemple, premier bord périphérique 3 peut être une ligne brisée ou une ligne courbe. Ainsi, le premier bord périphérique peut comprendre au moins une portion non rectiligne concave, et/ou au moins une portion non rectiligne convexe. En d'autres termes, une portion convexe correspondant à un creux sur le premier bord périphérique 3 sera dépourvu de premier pixel 5 le long de la première ligne périphérique 15, et/ou de la première colonne périphérique 17 ; alors qu'une portion concave correspondant à une bosse sur le premier bord périphérique 3 comprendra un premier pixel 5. L'ouverture de jonction 21 permet ainsi de former la première zone de jonction 19 simplement à partir d'un panneau d'affichage P1, P2 comprenant les pixels.

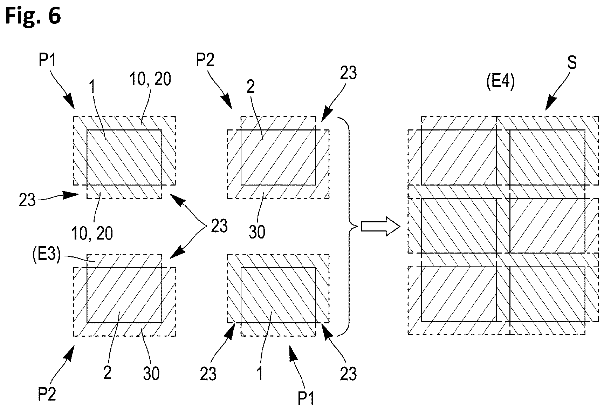

En référence à la figure 6 maintenant, la première surface de réception 1 peut comprendre une ouverture d'assemblage 23 ménagée à travers la première épaisseur e1 du support, au niveau d'un coin de la première surface de réception 1 quadrilatérale. De cette manière, il est possible de former un écran d'affichage S par une superposition partielle d'une pluralité de panneaux d'affichage tout en limitant les surépaisseurs au niveau des coins.

Enfin, le panneau d'affichage P1 comprend une pluralité de premiers éléments électriquement conducteurs 12 configurés pour assurer une connexion électrique entre tout ou partie des premiers pixels 5.

Les dispositions précédemment décrites permettent de proposer un panneau d'affichage P1, P2 pour écran d'affichage S dans lequel un alignement rectiligne des pixels sur un bord périphérique du panneau d'affichage P1, P2 est évité afin d'empêcher la visualisation de lignes droites au niveau de jonctions entre plusieurs panneaux d'affichage, une fois que le panneau d'affichage P1, P2 est assemblé à d'autres panneaux d'affichage P1, P2 pour former un écran d'affichage S.

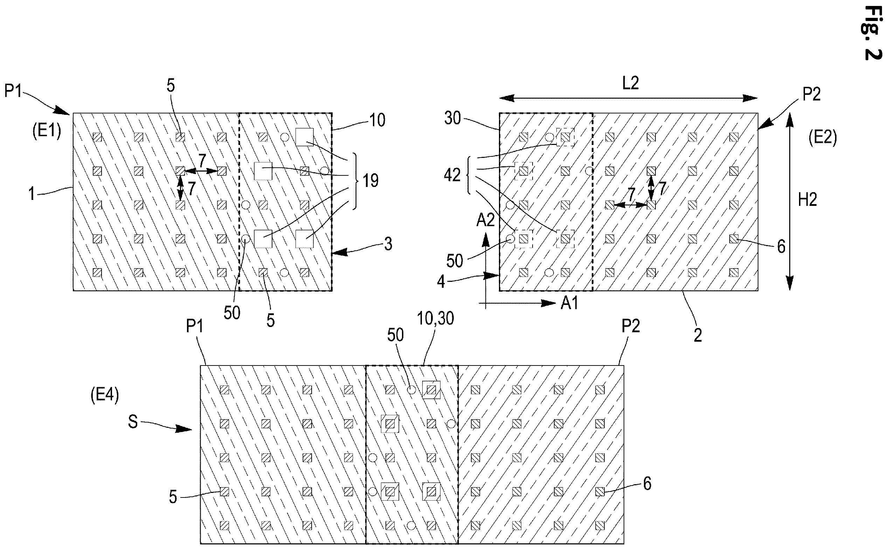

Comme cela a été indiqué plus haut, l'invention concerne également un écran d'affichage S dont des modes de réalisation sont représentés sur les figures 2, 3, 5, 6. Cet écran d'affichage S comprend notamment un premier panneau d'affichage P1 tel que décrit précédemment, et un deuxième panneau d'affichage P2 distinct du premier panneau d'affichage P1. Ce deuxième panneau d'affichage P2 est généralement du même type que le premier panneau d'affichage P1, et comprend un deuxième support comprenant une deuxième surface de réception 2 et une deuxième épaisseur e2 comptée transversalement à la deuxième surface de réception 2. Il peut notamment être prévu qu'une épaisseur choisie parmi la première épaisseur e1 et la deuxième épaisseur e2 soit comprise entre 25 µm et 700 µm. Il est donc possible de proposer un écran d'affichage S ayant une épaisseur très mince, de manière à ce que les pixels ou les diodes électroluminescentes soient bien visibles dans tous les angles de vue, et de manière à ce qu'elles soient quasiment dans le même plan visuel. Ainsi, il est possible d'éviter que certaines diodes électroluminescentes soient en retrait par rapport aux autres. Par ailleurs, dans le cas où la première épaisseur e1 et la deuxième épaisseur e2 sont inférieures à 200 µm, il est possible d'obtenir un écran d'affichage S flexible. De manière avantageuse, la première épaisseur e1 peut être comprise entre 25 µm et 200 µm, et la deuxième épaisseur e2, peut être strictement supérieure à 700 µm. Dans ce cas il est possible de placer le premier panneau d'affichage P1 au-dessus du deuxième panneau d'affichage P2.

Il est bien compris que l'utilisation des termes « premier » et « deuxième » n'est pas limitative et que selon le mode de réalisation, il peut y avoir au moins un panneau d'affichage supplémentaire de même nature que les premier et deuxième panneaux d'affichage P1, P2 et pour lequel les mêmes principes qu'eux s'appliquent.

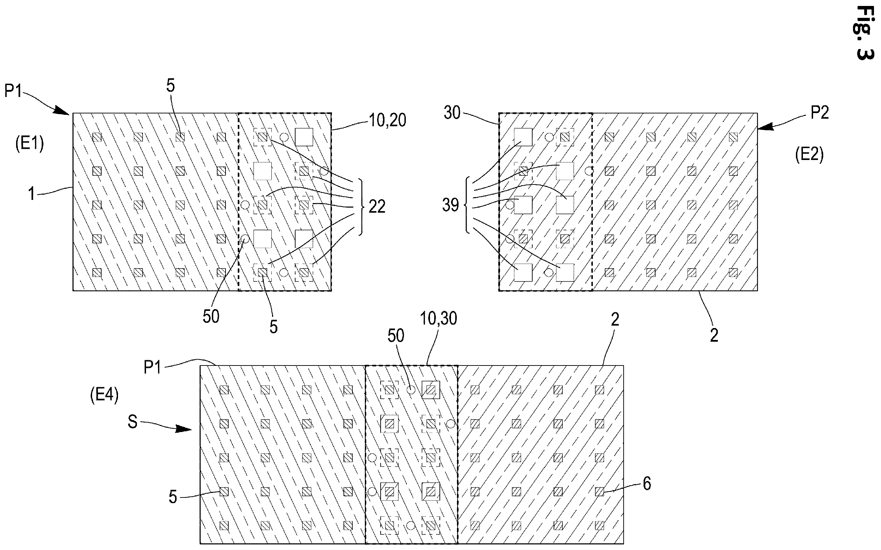

Comme cela est illustré sur les figures 2 et 3 la première surface de réception 1 du premier panneau d'affichage P1 peut être une surface de forme quadrilatérale, et la deuxième surface de réception 2 du deuxième panneau d'affichage P2 est une surface de forme quadrilatérale. La deuxième surface de réception 2 peut alors comprendre une deuxième longueur L2 correspondant à une plus grande dimension comptée le long du premier axe A1, et une deuxième hauteur H2 correspondant à une plus grande dimension comptée le long du deuxième axe A2. Généralement ces formes quadrilatérales de la première surface de réception 1 et de la deuxième surface de réception 2 sont des formes quadrilatérales de même nature. Par « formes quadrilatérales de même nature », on entend des formes quadrilatérales définies par le même type de quadrilatère, un type de quadrilatère étant par exemple choisi parmi : un carré, un rectangle, un losange, un parallélogramme, un trapèze, ou tout autre quadrilatère. Un tel mode de réalisation n'est pas limitatif, et la première surface de réception 1 et/ou la deuxième surface de réception 2 peuvent plus généralement présenter une forme de polygone. Les dispositions précédemment décrites permettent d'assembler plus simplement une pluralité de panneaux d'affichage pour former l'écran d'affichage S.

Pour simplifier l'assemblage des panneaux d'affichage, il peut être prévu que la première longueur L1 d'un premier côté de la première surface de réception 1 du premier panneau d'affichage P1 soit un multiple la deuxième longueur L2 d'un deuxième côté de la deuxième surface de réception 2 du deuxième panneau d'affichage P2. Par exemple la deuxième longueur est égale à la première longueur L1. Alternativement ou non, la deuxième hauteur H2 peut également être un multiple de la deuxième longueur L2, ou inversement. Par exemple la deuxième hauteur H2 est égale à la deuxième longueur L2.

La deuxième surface de réception 2 du deuxième support comprend au moins un deuxième bord périphérique 4 et inclut intérieurement au moins une deuxième portion de raccordement 30 adjacente au deuxième bord périphérique 4 de la deuxième surface de réception 2.

Le deuxième panneau d'affichage P2 comprend une matrice de deuxièmes pixels 6 définie par une organisation matricielle identique à celle de la matrice de premiers pixels 5 du premier panneau d'affichage P1. Cette matrice de deuxièmes pixels 6 comprend des deuxièmes pixels 6 agencés, sur tout ou partie de la deuxième surface de réception 2 et en dehors de la deuxième portion de raccordement 30, de manière régulière selon l'organisation matricielle. Cette matrice de deuxièmes pixels 6 comprend en outre des deuxièmes pixels 6 agencés à intervalles réguliers espacés entre eux suivant le premier pas 7 régulier au sein de la deuxième portion de raccordement 30.

La deuxième portion de raccordement 30 comprenant une deuxième zone de jonction 42 complémentaire de la première zone de jonction 19, et configurée pour coopérer avec la première zone de jonction 19 de la première portion de raccordement 10 du premier panneau d'affichage P1 de sorte qu'au moins un deuxième pixel 6 agencé au niveau de la deuxième zone de jonction soit disposé au niveau d'un emplacement 16 de la première zone de jonction 19.

Pour mettre en œuvre l'invention, l'homme du métier pourra choisir les panneaux d'affichages P1, P2, de sorte que chaque panneau d'affichage P1, P2 comprenne une ou plusieurs portions de raccordement comprenant chacune une ou plusieurs zones de jonction. Par exemple, chaque panneau d'affichage P1, P2 peut comprendre une portion de raccordement au niveau de chaque bord de la surface de réception. Par ailleurs, il est avantageux qu'au moins une portion de raccordement choisie parmi la première portion de raccordement 10 et la deuxième portion de raccordement 30 comprenne à la fois une première zone de jonction 22, 42 et une deuxième zone de jonction 19, 39. Ainsi, il est possible d'obtenir un écran d'affichage S de grande dimension par l'assemblage d'une pluralité de panneaux d'affichage. La présence de portions de raccordement entre deux panneaux d'affichage adjacent permet de rendre les jonctions entre les panneaux d'affichage floue, permettant ainsi d'éviter la formation de jonctions rectilignes visible à l'œil nu.

La première zone de jonction 19 du premier panneau d'affichage P1 peut comprendre au moins une ouverture de jonction 21 ménagée à travers la première épaisseur e1 du support du premier panneau d'affichage P1, au niveau de laquelle la deuxième zone de jonction 42 du deuxième panneau d'affichage P2 coopère avec la première zone de jonction 19 du premier panneau d'affichage P1.

Selon une première variante conforme à l'invention et illustrée sur les figures 2, 3, 5, et 6, la première zone de jonction 19 coopère avec la deuxième zone de jonction 42 par superposition. De cette manière, il est possible d'assembler le premier panneau d'affichage P1 et le deuxième panneau d'affichage P2 par tuilage, ce qui simplifie l'assemblage de l'écran d'affichage S.

Selon une deuxième variante qui ne correspond pas à l'invention telle que revendiquée et illustrée sur la figure 4 l'ouverture de jonction 21 de la première zone de jonction 19 du premier panneau d'affichage P1 est ménagée sur le premier bord périphérique 3 de la première surface de réception 1, et la deuxième zone de jonction 42 de la deuxième portion de raccordement 30 forme le deuxième bord périphérique 4 de la deuxième surface de réception 2. La deuxième zone de jonction 42 s'étend donc en saillie depuis la deuxième surface de réception 2, et le premier bord périphérique 3 de la première surface de réception 1 a une forme complémentaire du deuxième bord périphérique 4 de la deuxième surface de réception 2. Pour former l'écran d'affichage S, la deuxième zone de jonction 42 et la première zone d'jonction 19 sont alors disposées côte à côte dans le plan de la première surface de réception 1 et de la deuxième surface de réception 2. En d'autres termes la deuxième zone de jonction 42 de la deuxième portion de raccordement 30 fait saillie dans le plan de la deuxième surface de réception 2. L'obtention des panneaux d'affichage P1, P2 selon cette variante peut être faite par un découpage non rectiligne de la première surface de réception 1, complémentaire d'un découpage non rectiligne de la deuxième surface de réception 2. Par exemple, le premier bord périphérique 3 de la première surface de réception 1 est dentelé ou crénelé de manière complémentaire du deuxième bord périphérique 4 de la deuxième surface de réception 2 qui est également dentelé ou crénelé.

Comme illustré sur la figure 6, au moins un panneau d'affichage P1, P2 choisi parmi le premier panneau d'affichage P1 et le deuxième panneau d'affichage P2 comprend une ouverture d'assemblage 23 ménagée à travers l'épaisseur e1, e2 du support dudit au moins un panneau d'affichage P1, P2, au niveau d'un coin de la surface de réception 1, 2 quadrilatérale de ce panneau d'affichage P1, P2. Il est donc bien compris que la surface totale de la surface de réception 1, 2 quadrilatérale est diminuée par le retrait de l'ouverture d'assemblage 23. Avantageusement, il peut être prévu qu'un coin d'une surface de réception 1, 2 d'un panneau d'affichage adjacent au panneau d'affichage P1, P2 comprenant l'ouverture d'assemblage 23 vienne compléter la surface de réception 1, 2 au niveau de l'ouverture d'assemblage 23.

En référence maintenant à la figure 5, le deuxième panneau d'affichage P2 comprend également une pluralité de deuxièmes éléments électriquement conducteurs 32 configurés pour assurer une connexion électrique entre tout ou partie des deuxièmes pixels 6. L'écran d'affichage S peut comprendre en outre un élément de connexion électrique 50 configuré pour assurer une connexion électrique entre tout ou partie des deuxièmes éléments électriquement conducteurs 32 du deuxième panneau d'affichage P2 et tout ou partie des premiers éléments électriquement conducteurs 12 du premier panneau d'affichage P1. De cette manière, tous les premiers pixels 5 et les deuxièmes pixels 6 peuvent être alimentés simultanément en énergie électrique. Le mode de réalisation illustré sur la figure 5 présente l'élément de connexion électrique 50 qui comprend une pluralité d'aiguilles conductrices traversant au moins partiellement la première épaisseur e1 du support du premier panneau d'affichage P1 et traversant au moins partiellement une deuxième épaisseur e2 du support du deuxième panneau d'affichage P2, ladite deuxième épaisseur e2 du support du deuxième panneau d'affichage P2 étant comptée transversalement à la deuxième surface de réception 2. Selon un autre mode de réalisation non représenté, l'élément de connexion électrique 50 peut comprendre un agent adhésif électriquement conducteur. De cette manière, l'élément de connexion électrique 50 permet d'assurer à la fois la connexion électrique entre les premiers pixels 5, et les deuxièmes pixels 6, mais aussi de maintenir mécaniquement le premier panneau d'affichage P1 et le deuxième panneau d'affichage P2. Il est donc bien compris qu'il est possible que la pluralité de premiers éléments électriquement conducteurs 12, et la pluralité de deuxièmes éléments électriquement conducteurs 32 soient commandés électriquement individuellement. En d'autres termes, le premier panneau d'affichage P1 et le deuxième panneau d'affichage P2 sont commandés électriquement individuellement via les premiers et deuxièmes éléments électriquement conducteurs 12, 32 qui peuvent ensuite être connectés les uns aux autres via l'élément de connexion électrique 50.

Les dispositions précédemment décrites permettent d'assembler un premier panneau d'affichage P1 et un deuxième panneau d'affichage P2 de sorte à former un écran d'affichage S. De manière avantageuse, la coopération entre la première zone de jonction 19 de la première portion de raccordement 10 et la deuxième zone de jonction 42 de la deuxième portion de raccordement 30 permet de masquer tout éventuel effet de jonction rectiligne entre le premier panneau d'affichage P1 et le deuxième panneau d'affichage P2. En d'autres termes, il est possible de rendre floue la jonction entre les deux panneaux d'affichage par la coopération de la première portion de raccordement 10 avec la deuxième portion de raccordement 30, car les premiers pixels 5 et deuxièmes pixels 6 au niveau de la jonction des deux panneaux d'affichage P1, P2, ne sont plus forcément alignés suivant le premier axe A1 ou selon le deuxième axe A2 de l'autre panneau d'affichage P1, P2. Cependant, dans l'écran d'affichage S résultant de l'assemblage du premier panneau P1 et du deuxième panneau P2 tous les pixels de la première zone de jonction 19 et de la deuxième zone de jonction 42 sont parfaitement alignés suivant le premier axe A1 et/ou selon le deuxième axe A2.

Enfin, l'invention concerne un procédé de fabrication d'un écran d'affichage S comprenant :
- une étape E1 de fourniture d'un premier panneau d'affichage P1 tel que décrit précédemment et ;
- une étape E2 de fourniture d'un deuxième panneau d'affichage P2 comprenant :
   ∘ un deuxième support comprenant une deuxième surface de réception 2, ladite deuxième surface de réception 2 comprenant au moins un deuxième bord périphérique 4 et incluant intérieurement au moins une deuxième portion de raccordement 30 adjacente audit au moins un deuxième bord périphérique 4 de la deuxième surface de réception 2 ;
   ∘ une matrice de deuxièmes pixels 6 définie par une organisation matricielle identique à celle de la matrice de premiers pixels 5 du premier panneau d'affichage P1, ladite matrice de deuxièmes pixels 6 comprenant des deuxièmes pixels 6 agencés, sur tout ou partie de la deuxième surface de réception 2 et en dehors de la deuxième portion de raccordement 30, de manière régulière selon l'organisation matricielle, et des deuxièmes pixels 6 agencés à intervalles réguliers espacés entre eux suivant le premier pas 7 régulier au sein de la deuxième portion de raccordement 30, la deuxième portion de raccordement 30 comprenant une deuxième zone de jonction 42 configurée pour coopérer avec la première zone de jonction 19 de la première portion de raccordement 10 du premier panneau d'affichage P1 de sorte qu'au moins un deuxième pixel 6 agencé au niveau de la deuxième zone de jonction soit disposé au niveau d'un emplacement 16 de la première zone de jonction 19 ;
   o une pluralité de deuxièmes éléments électriquement conducteurs 32 configurés pour assurer une connexion électrique entre tout ou partie des deuxièmes pixels 6.

Par exemple, l'étape E1 de fourniture du premier panneau d'affichage P1 peut comprendre une étape de mise à disposition d'un premier panneau d'affichage initial comprenant le premier support, une matrice initiale de premiers pixels 5 définie par l'organisation matricielle, ladite matrice initiale de premiers pixels 5 comprenant des premiers pixels 5 agencés sur tout ou partie de la première surface de réception 1 de manière régulière selon l'organisation matricielle, et la pluralité de premiers éléments électriquement conducteurs 12 configurés pour assurer une connexion électrique entre tout ou partie des premiers pixels 5. L'étape E1 de fourniture du premier panneau d'affichage peut alors ensuite comprendre une étape de formation d'une première zone de jonction 19 dans laquelle au moins un premier pixel 5 est supprimé d'au moins un emplacement 16 choisi parmi le premier ensemble 14 et le deuxième ensemble 18, de sorte que ledit au moins un emplacement 16 soit dépourvu de pixel. Cette étape de formation de la première zone de jonction 19 peut comprendre la formation d'au moins une ouverture de jonction 21 à travers la première épaisseur e1 du support du premier panneau d'affichage P1.

Ensuite, et notamment dans le cas où une surface de réception choisie parmi la première surface de réception 1 du premier panneau d'affichage P1 et la deuxième surface de réception 2 du deuxième panneau d'affichage P2 est une surface de forme quadrilatérale, le procédé de fabrication peut comprendre une étape E3 de création d'une ouverture d'assemblage 23, dans laquelle une ouverture d'assemblage 23 est créée au niveau d'un coin de ladite au moins une surface de réception.

Enfin, le procédé de fabrication comprend une étape E4 d'assemblage de l'écran d'affichage S dans laquelle le premier panneau d'affichage P1 et le deuxième panneau d'affichage P2 sont assemblés de sorte qu'un deuxième pixel 6 du deuxième panneau d'affichage P2 soit disposé au niveau de la première zone de jonction 19 de la première portion de raccordement 10 du premier panneau d'affichage P1. Dans le cas où une étape de formation de la première zone de jonction 19 comprend la formation d'au moins une ouverture de jonction 21, l'étape E4 d'assemblage de l'écran d'affichage S peut être mise en œuvre par la superposition de la première portion de raccordement 10 du premier panneau d'affichage P1 et de la deuxième portion de raccordement 30 du deuxième panneau d'affichage P2.

Les dispositions précédemment décrites permettent de proposer un procédé de fabrication d'un écran d'affichage S comprenant plusieurs panneaux d'affichage, la jonction rectiligne entre deux panneaux d'affichage adjacents de l'écran d'affichage S étant rendue floue par le positionnement d'au moins un deuxième pixel 6 au niveau de la première zone de jonction 19 de la première portion de raccordement 10.

## Revendications

1. Panneau d'affichage (P1, P2) pour écran d'affichage (S), l'écran d'affichage (S) étant destiné à comprendre une pluralité de tels panneaux d'affichage (P1, P2) disposés côte à côte, ledit panneau d'affichage (P1, P2) comprenant :
- un support comprenant une première surface de réception (1) et une première épaisseur (e1) comptée transversalement à la première surface de réception (1), ladite première surface de réception (1) comprenant au moins un premier bord périphérique (3) et incluant intérieurement au moins une première portion de raccordement (10) adjacente audit au moins un premier bord périphérique (3) de la première surface de réception (1) ;
- une matrice de premiers pixels (5) définie par une organisation matricielle **caractérisée par** un premier axe (A1), un deuxième axe (A2), et un premier pas (7) régulier, ladite matrice de premiers pixels (5) comprenant des premiers pixels (5) agencés sur tout ou partie de la première surface de réception (1) et en dehors de la première portion de raccordement (10), de manière régulière selon l'organisation matricielle, et des premiers pixels (5) agencés, au sein de l'au moins une première portion de raccordement (10), le long :
• d'au moins une première ligne périphérique (15) orientée suivant le premier axe (A1) et comprenant un premier ensemble (14) d'emplacements échelonnés à intervalles réguliers espacés entre eux suivant ledit premier pas (7) régulier, le nombre de premiers pixels (5) appartenant à ladite première ligne périphérique (15) étant strictement inférieur au nombre d'emplacements inclus dans ledit premier ensemble (14) de sorte qu'au moins un emplacement du premier ensemble (14) soit dépourvu de pixel;
• et/ou d'au moins une première colonne périphérique (17) orientée suivant le deuxième axe (A2) et comprenant un deuxième ensemble (18) d'emplacements échelonnés à intervalles réguliers espacés entre eux suivant ledit premier pas (7) régulier, le nombre de premiers pixels (5) appartenant à ladite première colonne périphérique (17) étant strictement inférieur au nombre d'emplacements inclus dans ledit deuxième ensemble (18) de sorte qu'au moins un emplacement du deuxième ensemble (18) soit dépourvu de pixel ;
- une pluralité de premiers éléments électriquement conducteurs (12) configurés pour assurer une connexion électrique entre tout ou partie des premiers pixels (5) ;
au moins un emplacement choisi parmi ledit au moins un emplacement du premier ensemble (14) dépourvu de pixel et ledit au moins un emplacement du deuxième ensemble (18) dépourvu de pixel formant une première zone de jonction (19) de la première portion de raccordement (10), le support comprenant, au niveau de la première zone de jonction (19), une ouverture de jonction (21) ménagée à travers la première épaisseur (e1) du support, le panneau d'affichage étant **caractérisé en ce que** ladite ouverture de jonction (21) est disjointe du premier bord périphérique (3) de la première surface de réception (1).

2. Panneau d'affichage (P1, P2) selon la revendication 1, dans lequel la première surface de réception (1) est une surface de forme quadrilatérale.

3. Panneau d'affichage (P1, P2) selon la revendication 2, dans lequel la première surface de réception (1) comprend une ouverture d'assemblage (23) ménagée à travers la première épaisseur (e1) du support, au niveau d'un coin de la première surface de réception (1) quadrilatérale.

4. Écran d'affichage (S) comprenant :
- un premier panneau d'affichage (P1) selon l'une quelconque des revendications 1 à 3;
- un deuxième panneau d'affichage (P2) distinct du premier panneau d'affichage (P1) et comprenant :
• un deuxième support comprenant une deuxième surface de réception (2) et une deuxième épaisseur (e2) comptée transversalement à la deuxième surface de réception (2), ladite deuxième surface de réception (2) comprenant au moins un deuxième bord périphérique (4) et incluant intérieurement au moins une deuxième portion de raccordement (30) adjacente audit au moins un deuxième bord périphérique (4) de la deuxième surface de réception (2) ;
• une matrice de deuxièmes pixels (6) définie par une organisation matricielle identique à celle de la matrice de premiers pixels (5) du premier panneau d'affichage (P1), ladite matrice de deuxièmes pixels (6) comprenant des deuxièmes pixels (6) agencés, sur tout ou partie de la deuxième surface de réception (2) et en dehors de la deuxième portion de raccordement (30), de manière régulière selon l'organisation matricielle, et des deuxièmes pixels (6) agencés à intervalles réguliers espacés entre eux suivant le premier pas (7) régulier au sein de la deuxième portion de raccordement (30), la deuxième portion de raccordement (30) comprenant une deuxième zone de jonction (42) complémentaire de la première zone de jonction (19), et configurée pour coopérer avec la première zone de jonction (19) de la première portion de raccordement (10) du premier panneau d'affichage (P1) de sorte qu'au moins un deuxième pixel (6) agencé au niveau de la deuxième zone de jonction soit disposé au niveau d'un emplacement (16) de la première zone de jonction (19) ; et
• une pluralité de deuxièmes éléments électriquement conducteurs (32) configurés pour assurer une connexion électrique entre tout ou partie des deuxièmes pixels (6).

5. Écran d'affichage (S) selon la revendication 4, dans lequel le deuxième panneau d'affichage (P2) est un panneau d'affichage selon l'une quelconque des revendications 1 à 3.

6. Écran d'affichage (S) selon l'une quelconque des revendications 4 ou 5, dans lequel la première surface de réception (1) du premier panneau d'affichage (P1) est une surface de forme quadrilatérale, et dans lequel la deuxième surface de réception (2) du deuxième panneau d'affichage (P2) est une surface de forme quadrilatérale, lesdites formes quadrilatérales de la première surface de réception (1) et de la deuxième surface de réception (2) étant des formes quadrilatérales de même nature.

7. Écran d'affichage (S) selon la revendication 6, dans lequel au moins un panneau d'affichage (P1, P2) choisi parmi le premier panneau d'affichage (P1) et le deuxième panneau d'affichage (P2) comprend une ouverture d'assemblage (23) ménagée à travers l'épaisseur (e1, e2) du support dudit au moins un panneau d'affichage (P1, P2), au niveau d'un coin de la surface de réception (1, 2) quadrilatérale de ce panneau d'affichage (P1, P2).

8. Écran d'affichage (S) selon l'une quelconque des revendications 6 ou 7, dans lequel une première longueur (L1) d'un premier côté de la première surface de réception (1) du premier panneau d'affichage (P1) est un multiple d'une deuxième longueur (L2) d'un deuxième côté de la deuxième surface de réception (2) du deuxième panneau d'affichage (P2).

9. Écran d'affichage (S) selon l'une quelconque des revendications 4 à 8, comprenant un élément de connexion électrique (50) configuré pour assurer une connexion électrique entre tout ou partie des deuxièmes éléments électriquement conducteurs (32) du deuxième panneau d'affichage (P2) et tout ou partie des premiers éléments électriquement conducteurs (12) du premier panneau d'affichage (P1).

10. Écran d'affichage (S) selon la revendication 9, dans lequel l'élément de connexion électrique (50) comprend une pluralité d'aiguilles conductrices traversant au moins partiellement la première épaisseur (e1) du support du premier panneau d'affichage (P1) et traversant au moins partiellement une deuxième épaisseur (e2) du support du deuxième panneau d'affichage (P2), ladite deuxième épaisseur (e2) du support du deuxième panneau d'affichage (P2) étant comptée transversalement à la deuxième surface de réception (2).

11. Écran d'affichage (S) selon la revendication 4 à 10, dans lequel au moins une épaisseur choisie parmi la première épaisseur (e1) et la deuxième épaisseur (e2), est comprise entre 25 µm et 700 µm.

12. Procédé de fabrication d'un écran d'affichage (S) comprenant :
- une étape (E1) de fourniture d'un premier panneau d'affichage (P1) selon l'une quelconque des revendications 1 à 3 ;
- une étape (E2) de fourniture d'un deuxième panneau d'affichage (P2) comprenant :
• un deuxième support comprenant une deuxième surface de réception (2), ladite deuxième surface de réception (2) comprenant au moins un deuxième bord périphérique (4) et incluant intérieurement au moins une deuxième portion de raccordement (30) adjacente audit au moins un deuxième bord périphérique (4) de la deuxième surface de réception (2) ;
• une matrice de deuxièmes pixels (6) définie par une organisation matricielle identique à celle de la matrice de premiers pixels (5) du premier panneau d'affichage (P1), ladite matrice de deuxièmes pixels (6) comprenant des deuxièmes pixels (6) agencés, sur tout ou partie de la deuxième surface de réception (2) et en dehors de la deuxième portion de raccordement (30), de manière régulière selon l'organisation matricielle, et des deuxièmes pixels (6) agencés à intervalles réguliers espacés entre eux suivant le premier pas (7) régulier au sein de la deuxième portion de raccordement (30), la deuxième portion de raccordement (30) comprenant une deuxième zone de jonction (42) configurée pour coopérer avec la première zone de jonction (19) de la première portion de raccordement (10) du premier panneau d'affichage (P1) de sorte qu'au moins un deuxième pixel (6) agencé au niveau de la deuxième zone de jonction soit disposé au niveau d'un emplacement (16) de la première zone de jonction (19) ;
• une pluralité de deuxièmes éléments électriquement conducteurs (32) configurés pour assurer une connexion électrique entre tout ou partie des deuxièmes pixels (6) ;
- une étape (E4) d'assemblage de l'écran d'affichage (S) dans laquelle le premier panneau d'affichage (P1) et le deuxième panneau d'affichage (P2) sont assemblés de sorte qu'un deuxième pixel (6) du deuxième panneau d'affichage (P2) soit disposé au niveau de la première zone de jonction (19) de la première portion de raccordement (10) du premier panneau d'affichage (P1).

13. Procédé de fabrication selon la revendication 12, dans lequel l'étape (E1) de fourniture du premier panneau d'affichage (P1) comprend :
- une étape de mise à disposition d'un premier panneau d'affichage initial comprenant :
• le premier support ;
• une matrice initiale de premiers pixels (5) définie par l'organisation matricielle, ladite matrice initiale de premiers pixels (5) comprenant des premiers pixels (5) agencés sur tout ou partie de la première surface de réception (1) de manière régulière selon l'organisation matricielle ;
• la pluralité de premiers éléments électriquement conducteurs (12) configurés pour assurer une connexion électrique entre tout ou partie des premiers pixels (5) ;
- une étape de formation d'une première zone de jonction (19) dans laquelle au moins un premier pixel (5) est supprimé d'au moins un emplacement (16) choisi parmi le premier ensemble (14) et le deuxième ensemble (18), de sorte que ledit au moins un emplacement (16) soit dépourvu de pixel, ladite étape de formation de la première zone de jonction (19) comprenant la formation d'au moins une ouverture de jonction (21) à travers la première épaisseur (e1) du support du premier panneau d'affichage (P1) et disjoint du premier bord périphérique (3), l'étape (E4) d'assemblage de l'écran d'affichage (S) comprenant alors la superposition de la première portion de raccordement (10) du premier panneau d'affichage (P1) et de la deuxième portion de raccordement (30) du deuxième panneau d'affichage (P2).

14. Procédé de fabrication selon l'une quelconque des revendications 12 ou 13, dans lequel au moins une surface de réception choisie parmi la première surface de réception (1) du premier panneau d'affichage (P1) et la deuxième surface de réception (2) du deuxième panneau d'affichage (P2) est une surface de forme quadrilatérale, le procédé de fabrication comprenant une étape (E3) de création d'une ouverture d'assemblage (23), dans laquelle une ouverture d'assemblage (23) est créée au niveau d'un coin de ladite au moins une surface de réception.

## Patentansprüche

1. Anzeigefeld (P1, P2) für einen Anzeigebildschirm (S), wobei der Anzeigebildschirm (S) dazu bestimmt ist, eine Vielzahl solcher nebeneinander angeordneter Anzeigefelder (P1, P2) zu umfassen, wobei das Anzeigefeld (P1, P2) Folgendes umfasst:
- einen Träger, der eine erste Aufnahmefläche (1) und eine erste Dicke (e1) umfasst, die quer zur ersten Aufnahmefläche (1) gezählt wird, wobei die erste Aufnahmefläche (1) mindestens eine erste Umfangskante (3) umfasst und innen mindestens einen ersten Anschlussabschnitt (10) einschließt, der an die mindestens eine erste Umfangskante (3) der ersten Aufnahmefläche (1) angrenzt;
- eine Matrix aus ersten Pixeln (5), die durch eine Matrixorganisation definiert ist, die durch eine erste Achse (A1), eine zweite Achse (A2) und einen ersten regelmäßigen Abstand (7) gekennzeichnet ist, wobei die Matrix aus ersten Pixeln (5) erste Pixel (5) umfasst, die auf der gesamten oder einem Teil der ersten Aufnahmefläche (1) und außerhalb des ersten Anschlussabschnitts (10) regelmäßig gemäß der Matrixorganisation angeordnet sind, und erste Pixel (5), die innerhalb des mindestens einen ersten Anschlussabschnitts (10) entlang Folgendem angeordnet sind:
• mindestens einer ersten Umfangslinie (15), die entlang der ersten Achse (A1) ausgerichtet ist und eine erste Gruppe (14) von Positionen umfasst, die in regelmäßigen Abständen versetzt sind, die entlang des ersten regelmäßigen Abstands (7) voneinander beabstandet sind, wobei die Anzahl der ersten Pixel (5), die zu der ersten Umfangslinie (15) gehören, strikt geringer ist als die Anzahl der Positionen, die in der ersten Gruppe (14) enthalten sind, so dass mindestens eine Position der ersten Gruppe (14) kein Pixel aufweist;
• und/oder mindestens einer ersten Randspalte (17), die entlang der zweiten Achse (A2) ausgerichtet ist und eine zweite Gruppe (18) von Positionen umfasst, die in regelmäßigen Abständen versetzt sind, die entlang des ersten regelmäßigen Abstands (7) voneinander beabstandet sind, wobei die Anzahl der ersten Pixel (5), die zu der ersten Randspalte (17) gehören, strikt geringer ist als die Anzahl der Positionen, die in der zweiten Gruppe (18) enthalten sind, so dass mindestens eine Position der zweiten Gruppe (18) kein Pixel aufweist;
- eine Vielzahl von ersten elektrisch leitenden Elementen (12), die so eingerichtet sind, dass sie eine elektrische Verbindung zwischen allen oder einem Teil der ersten Pixel (5) gewährleisten;
wobei mindestens eine Position, die aus der mindestens einen Position der ersten Gruppe (14), die kein Pixel aufweist, und der mindestens einen Position der zweiten Gruppe (18), die kein Pixel aufweist, ausgewählt ist, einen ersten Verbindungsbereich (19) des ersten Anschlussabschnitts (10) bildet, wobei der Träger auf Höhe des ersten Verbindungsbereichs (19) eine durch die erste Dicke (e1) des Trägers ausgebildete Verbindungsöffnung (21) umfasst, wobei das Anzeigefeld **dadurch gekennzeichnet ist, dass** die Verbindungsöffnung (21) von der ersten Umfangskante (3) der ersten Aufnahmefläche (1) getrennt ist.

2. Anzeigefeld (P1, P2) nach Anspruch 1, wobei die erste Aufnahmefläche (1) eine Fläche von vierseitiger Form ist.

3. Anzeigefeld (P1, P2) nach Anspruch 2, wobei die erste Aufnahmefläche (1) eine durch die erste Dicke (e1) des Trägers ausgebildete Montageöffnung (23) an einer Ecke der ersten vierseitigen Aufnahmefläche (1) umfasst.

4. Anzeigebildschirm (S), der Folgendes umfasst:
- ein erstes Anzeigefeld (P1) nach einem der Ansprüche 1 bis 3;
- ein zweites Anzeigefeld (P2), das von dem ersten Anzeigefeld (P1) getrennt ist und Folgendes umfasst:
• einen zweiten Träger, der eine zweite Aufnahmefläche (2) und eine zweite Dicke (e2) umfasst, die quer zur zweiten Aufnahmefläche (2) gezählt wird, wobei die zweite Aufnahmefläche (2) mindestens eine zweite Umfangskante (4) umfasst und innen mindestens einen zweiten Anschlussabschnitt (30) einschließt, der an die mindestens eine zweite Umfangskante (4) der zweiten Aufnahmefläche (2) angrenzt;
• eine Matrix aus zweiten Pixeln (6), die durch eine Matrixorganisation definiert ist, die identisch mit der Matrix aus ersten Pixeln (5) des ersten Anzeigefelds (P1) ist, wobei die Matrix aus zweiten Pixeln (6) zweite Pixel (6) umfasst, die auf der gesamten oder einem Teil der zweiten Aufnahmefläche (2) und außerhalb des zweiten Anschlussabschnitts (30) regelmäßig gemäß der Matrixorganisation angeordnet sind, und zweite Pixel (6) umfasst, die in regelmäßigen Abständen angeordnet sind, die entlang des ersten regelmäßigen Abstands (7) innerhalb des zweiten Anschlussabschnitts (30) voneinander beabstandet sind, wobei der zweite Anschlussabschnitt (30) einen zweiten Verbindungsbereich (42) umfasst, der komplementär zu dem ersten Verbindungsbereich (19) ist und so eingerichtet ist, dass er mit dem ersten Verbindungsbereich (19) des ersten Anschlussabschnitts (10) des ersten Anzeigefelds (P1) zusammenarbeitet, so dass mindestens ein zweites Pixel (6), das an dem zweiten Verbindungsbereich angeordnet ist, an einer Position (16) des ersten Verbindungsbereichs (19) angeordnet ist; und
• eine Vielzahl von zweiten elektrisch leitenden Elementen (32), die so eingerichtet sind, dass sie eine elektrische Verbindung zwischen allen oder einem Teil der zweiten Pixel (6) gewährleisten.

5. Anzeigebildschirm (S) nach Anspruch 4, wobei das zweite Anzeigefeld (P2) ein Anzeigefeldnach einem der Ansprüche 1 bis 3 ist.

6. Anzeigebildschirm (S) nach einem der Ansprüche 4 oder 5, wobei die erste Aufnahmefläche (1) des ersten Anzeigefelds (P1) eine Fläche von vierseitiger Form ist, und wobei die zweite Aufnahmefläche (2) des zweiten Anzeigefelds (P2) eine Fläche von vierseitiger Form ist, wobei die vierseitigen Formen der ersten Aufnahmefläche (1) und der zweiten Aufnahmefläche (2) gleichartige vierseitige Formen sind.

7. Anzeigebildschirm (S) nach Anspruch 6, wobei mindestens ein Anzeigefeld (P1, P2), das aus dem ersten Anzeigefeld (P1) und dem zweiten Anzeigefeld (P2) ausgewählt ist, eine durch die Dicke (e1, e2) des Trägers des mindestens einen Anzeigefelds (P1, P2) ausgebildete Montageöffnung (23) an einer Ecke der vierseitigen Aufnahmefläche (1, 2) des Anzeigefelds (P1, P2) umfasst.

8. Anzeigebildschirm (S) nach einem der Ansprüche 6 oder 7, wobei eine erste Länge (L1) auf einer ersten Seite der ersten Aufnahmefläche (1) des ersten Anzeigefelds (P1) ein Vielfaches einer zweiten Länge (L2) auf einer zweiten Seite der zweiten Aufnahmefläche (2) des zweiten Anzeigefelds (P2) ist.

9. Anzeigebildschirm (S) nach einem der Ansprüche 4 bis 8, umfassend ein elektrisches Verbindungselement (50), das so eingerichtet ist, dass es eine elektrische Verbindung zwischen allen oder einem Teil der zweiten elektrisch leitenden Elemente (32) des zweiten Anzeigefelds (P2) und allen oder einem Teil der ersten elektrisch leitenden Elemente (12) des ersten Anzeigefelds (P1) gewährleistet.

10. Anzeigebildschirm (S) nach Anspruch 9, wobei das elektrische Verbindungselement (50) eine Vielzahl von leitenden Nadeln umfasst, die mindestens teilweise durch die erste Dicke (e1) des Trägers des ersten Anzeigefelds (P1) und mindestens teilweise durch eine zweite Dicke (e2) des Trägers des zweiten Anzeigefelds (P2) verlaufen, wobei die zweite Dicke (e2) des Trägers des zweiten Anzeigefelds (P2) quer zur zweiten Aufnahmefläche (2) gezählt wird.

11. Anzeigebildschirm (S) nach Anspruch 4 bis 10, wobei mindestens eine Dicke, die aus der ersten Dicke (e1) und der zweiten Dicke (e2) ausgewählt ist, zwischen 25 µm und 700 µm beträgt.

12. Verfahren zur Herstellung eines Anzeigebildschirms (S), das Folgendes umfasst:
- einen Schritt (E1) des Bereitstellens eines ersten Anzeigefelds (P1) nach einem der Ansprüche 1 bis 3;
- einen Schritt (E2) des Bereitstellens eines zweiten Anzeigefelds (P2), das Folgendes umfasst:
• einen zweiten Träger, die eine zweite Aufnahmefläche (2) umfasst, wobei die zweite Aufnahmefläche (2) mindestens eine zweite Umfangskante (4) umfasst und innen mindestens einen zweiten Anschlussabschnitt (30) einschließt, der an die mindestens eine zweite Umfangskante (4) der zweiten Aufnahmefläche (2) angrenzt;
• eine Matrix aus zweiten Pixeln (6), die durch eine Matrixorganisation definiert ist, die identisch mit der Matrix aus ersten Pixeln (5) des ersten Anzeigefelds (P1) ist, wobei die Matrix aus zweiten Pixeln (6) zweite Pixel (6) umfasst, die auf der gesamten oder einem Teil der zweiten Aufnahmefläche (2) und außerhalb des zweiten Anschlussabschnitts (30) regelmäßig gemäß der Matrixorganisation angeordnet sind, und zweite Pixel (6) umfasst, die in regelmäßigen Abständen angeordnet sind, die entlang des ersten regelmäßigen Abstands (7) innerhalb des zweiten Anschlussabschnitts (30) voneinander beabstandet sind, wobei der zweite Anschlussabschnitt (30) einen zweiten Verbindungsbereich (42) umfasst, der so eingerichtet ist, dass er mit dem ersten Verbindungsbereich (19) des ersten Anschlussabschnitts (10) des ersten Anzeigefelds (P1) zusammenarbeitet, so dass mindestens ein zweites Pixel (6), das an dem zweiten Verbindungsbereich angeordnet ist, an einer Position (16) des ersten Verbindungsbereichs (19) angeordnet ist;
• eine Vielzahl von zweiten elektrisch leitenden Elementen (32), die so eingerichtet sind, dass sie eine elektrische Verbindung zwischen allen oder einem Teil der zweiten Pixel (6) gewährleisten;
- einen Schritt (E4) des Montierens des Anzeigebildschirms (S), bei dem das erste Anzeigefeld (P1) und das zweite Anzeigefeld (P2) so montiert werden, dass ein zweites Pixel (6) des zweiten Anzeigefelds (P2) an dem ersten Verbindungsbereich (19) des ersten Anschlussabschnitts (10) des ersten Anzeigefelds (P1) angeordnet ist.

13. Herstellungsverfahren nach Anspruch 12, wobei der Schritt (E1) des Bereitstellens des ersten Anzeigefelds (P1) Folgendes umfasst:
- einen Schritt des Bereitstellens eines anfänglichen ersten Anzeigefelds, das Folgendes umfasst:
• den ersten Träger;
• eine anfängliche Matrix aus ersten Pixeln (5), die durch die Matrixorganisation definiert ist, wobei die anfängliche Matrix aus ersten Pixeln (5) erste Pixel (5) umfasst, die auf der gesamten oder einem Teil der ersten Aufnahmefläche (1) regelmäßig gemäß der Matrixorganisation angeordnet sind;
• die Vielzahl von ersten elektrisch leitenden Elementen (12), die so eingerichtet sind, dass sie eine elektrische Verbindung zwischen allen oder einem Teil der ersten Pixel (5) gewährleisten;
- einen Schritt des Bildens eines ersten Verbindungsbereichs (19), bei dem mindestens ein erstes Pixel (5) aus mindestens einer Position (16) entfernt wird, die aus der ersten Gruppe (14) und der zweiten Gruppe (18) ausgewählt ist, so dass die mindestens eine Position (16) kein Pixel aufweist, wobei der Schritt des Bildens des ersten Verbindungsbereichs (19) das Bilden von mindestens einer Verbindungsöffnung (21) durch die erste Dicke (e1) des Trägers des ersten Anzeigefelds (P1) und getrennt von der ersten Umfangskante (3) umfasst, wobei der Schritt (E4) des Montierens des Anzeigebildschirms (S) dann die Überlagerung des ersten Anschlussabschnitts (10) des ersten Anzeigefelds (P1) und des zweiten Anschlussabschnitts (30) des zweiten Anzeigefelds (P2) umfasst.

14. Herstellungsverfahren nach einem der Ansprüche 12 oder 13, wobei mindestens eine Aufnahmefläche, die aus der ersten Aufnahmefläche (1) des ersten Anzeigefelds (P1) und der zweiten Aufnahmefläche (2) des zweiten Anzeigefelds (P2) ausgewählt ist, eine Fläche von vierseitiger Form ist, wobei das Herstellungsverfahren einen Schritt (E3) des Erzeugens einer Montageöffnung (23) umfasst, bei dem eine Montageöffnung (23) an einer Ecke der mindestens einen Aufnahmefläche erzeugt wird.

## Claims

1. A display panel (P1, P2) for a display screen (S), the display screen (S) being intended to comprise a plurality of such display panels (P1, P2) arranged side by side, said display panel (P1, P2) comprising:
- a support comprising a first receiving surface (1) and a first thickness (e1) measured transversely to the first receiving surface (1), said first receiving surface (1) comprising at least one first peripheral edge (3) and including internally at least one first connecting portion (10) adjacent to said at least one first peripheral edge (3) of the first receiving surface (1);
- a matrix of first pixels (5) defined by a matrix organization **characterized by** a first axis (A1), a second axis (A2), and a first regular pitch (7), said matrix of first pixels (5) comprising first pixels (5) arranged on all or part of the first receiving surface (1) and outside the first connecting portion (10), in a regular manner according to the matrix organization, and first pixels (5) arranged, within the at least one first connecting portion (10), along:
• at least one first peripheral line (15) oriented along the first axis (A1) and comprising a first set (14) of locations staggered at regular intervals spaced apart from each other according to said first regular pitch (7), the number of first pixels (5) belonging to said first peripheral line (15) being strictly less than the number of locations included in said first set (14) such that at least one location of the first set (14) is devoid of pixels;
• and/or at least one first peripheral column (17) oriented along the second axis (A2) and comprising a second set (18) of locations staggered at regular intervals spaced apart from each other according to said first regular pitch (7), the number of first pixels (5) belonging to said first peripheral column (17) being strictly less than the number of locations included in said second set (18) such that at least one location of the second set (18) is devoid of pixels;
- a plurality of first electrically conductive elements (12) configured to provide an electrical connection between all or part of the first pixels (5);
at least one location selected from said at least one location of the first set (14) devoid of pixels and said at least one location of the second set (18) devoid of pixels forming a first junction zone (19) of the first connecting portion (10), the support comprising, at the first junction zone (19), a junction opening (21) formed through the first thickness (e1) of the support, the display panel being **characterized in that** said junction opening (21) is disjoint from the first peripheral edge (3) of the first receiving surface (1).

2. The display panel (P1, P2) according to claim 1, wherein the first receiving surface (1) is a quadrilateral-shaped surface.

3. The display panel (P1, P2) according to claim 2, wherein the first receiving surface (1) comprises an assembly opening (23) formed through the first thickness (e1) of the support, at a corner of the first quadrilateral receiving surface (1).

4. The display screen (S) comprising:
- a first display panel (P1) according to any one of claims 1 to 3;
- a second display panel (P2) distinct from the first display panel (P1) and comprising:
• a second support comprising a second receiving surface (2) and a second thickness (e2) measured transversely to the second receiving surface (2), said second receiving surface (2) comprising at least one second peripheral edge (4) and internally including at least one second connecting portion (30) adjacent to said at least one second peripheral edge (4) of the second receiving surface (2);
• a matrix of second pixels (6) defined by a matrix organization identical to that of the matrix of first pixels (5) of the first display panel (P1), said matrix of second pixels (6) comprising second pixels (6) arranged, on all or part of the second receiving surface (2) and outside the second connecting portion (30), in a regular manner according to the matrix organization, and second pixels (6) arranged at regular intervals spaced apart from each other according to the first regular pitch (7) within the second connecting portion (30), the second connecting portion (30) comprising a second junction zone (42) complementary to the first junction zone (19), and configured to cooperate with the first junction zone (19) of the first connecting portion (10) of the first display panel (P1) such that at least one second pixel (6) arranged at the second junction zone is disposed at a location (16) of the first junction zone (19); and
• a plurality of second electrically conductive elements (32) configured to provide an electrical connection between all or part of the second pixels (6).

5. The display screen (S) according to claim 4, wherein the second display panel (P2) is a display panel according to any one of claims 1 to 3.

6. The display screen (S) according to any one of claims 4 or 5, wherein the first receiving surface (1) of the first display panel (P1) is a quadrilateral-shaped surface, and wherein the second receiving surface (2) of the second display panel (P2) is a quadrilateral-shaped surface, said quadrilateral shapes of the first receiving surface (1) and the second receiving surface (2) being quadrilateral shapes of the same nature.

7. The display screen (S) according to claim 6, wherein at least one display panel (P1, P2) selected from the first display panel (P1) and the second display panel (P2) comprises an assembly opening (23) provided through the thickness (e1, e2) of the support of said at least one display panel (P1, P2), at a corner of the quadrilateral receiving surface (1, 2) of this display panel (P1, P2).

8. The display screen (S) according to any one of claims 6 or 7, wherein a first length (L1) of a first side of the first receiving surface (1) of the first display panel (P1) is a multiple of a second length (L2) of a second side of the second receiving surface (2) of the second display panel (P2).

9. The display screen (S) according to any one of claims 4 to 8, comprising an electrical connection element (50) configured to provide an electrical connection between all or part of the second electrically conductive elements (32) of the second display panel (P2) and all or part of the first electrically conductive elements (12) of the first display panel (P1).

10. The display screen (S) according to claim 9, wherein the electrical connection element (50) comprises a plurality of conductive needles at least partially passing through the first thickness (e1) of the support of the first display panel (P1) and at least partially passing through a second thickness (e2) of the support of the second display panel (P2), said second thickness (e2) of the support of the second display panel (P2) being measured transversely to the second receiving surface (2).

11. The display screen (S) according to claim 4 to 10, wherein at least one thickness selected from the first thickness (e1) and the second thickness (e2) is comprised between 25 µm and 700 µm.

12. A method for manufacturing a display screen (5) comprising:
- a step (E1) of providing a first display panel (P1) according to any one of claims 1 to 3;
- a step (E2) of providing a second display panel (P2) comprising:
• a second support comprising a second receiving surface, said second receiving surface comprising at least one second peripheral edge and internally including at least one second connecting portion adjacent to said at least one second peripheral edge of the second receiving surface;
• a matrix of second pixels (6) defined by a matrix organization identical to that of the matrix of first pixels (5) of the first display panel (P1), said matrix of second pixels (6) comprising second pixels (6) arranged, on all or part of the second receiving surface (2) and outside the second connecting portion (30), in a regular manner according to the matrix organization, and second pixels (6) arranged at regular intervals spaced apart from each other according to the first regular pitch (7) within the second connecting portion (30), the second connecting portion (30) comprising a second junction zone (42) configured to cooperate with the first junction zone (19) of the first connecting portion (10) of the first display panel (P1) such that at least one second pixel (6) arranged at the second junction zone is disposed at a location (16) of the first junction zone (19);
• a plurality of second electrically conductive elements (32) configured to provide an electrical connection between all or part of the second pixels (6);
- a step (F4) of assembling the display screen (S) in which the first display panel (P1) and the second display panel (P2) are assembled such that a second pixel (6) of the second display panel (P2) is arranged at the first junction zone (19) of the first connecting portion (10) of the first display panel (P1).

13. The manufacturing method according to claim 12, wherein the step (E1) of providing the first display panel (P1) comprises:
- a step of providing a first initial display panel comprising:
• the first support;
• an initial matrix of first pixels (5) defined by the matrix organization, said initial matrix of first pixels (5) comprising first pixels (5) arranged on all or part of the first receiving surface (1) in a regular manner according to the matrix organization;
• the plurality of first electrically conductive elements (12) configured to provide an electrical connection between all or part of the first pixels (5);
- a step of forming a first junction zone (19) in which at least one first pixel (5) is removed from at least one location (16) selected from the first set (14) and the second set (18), so that said at least one location (16) is devoid of pixels, said step of forming the first junction zone (19) comprising the formation of at least one junction opening (21) through the first thickness (e1) of the support of the first display panel (P1) and disjointed from the first peripheral edge (3),
the step (E4) of assembling the display screen (S) then comprising the superposition of the first connecting portion (10) of the first display panel (P1) and the second connecting portion (30) of the second display panel (P2).

14. The manufacturing method according to any one of claims 12 or 13, wherein at least one receiving surface selected among the first receiving surface (1) of the first display panel (P1) and the second receiving surface (2) of the second display panel (P2) is a quadrilateral-shaped surface, the manufacturing method comprising a step (E3) of creating an assembly opening (23), in which an assembly opening (23) is created at a corner of said at least one receiving surface.
